(19) **Europäisches Patentamt**
**European Patent Office**
**Office européen des brevets**

(11) **EP 4 480 333 A1**

(12) **EUROPEAN PATENT APPLICATION**
published in accordance with Art. 153(4) EPC

(43) Date of publication:
**25.12.2024 Bulletin 2024/52**

(51) International Patent Classification (IPC):
**A24F 40/51** (2020.01)    **A24F 40/50** (2020.01)

(21) Application number: **22929388.1**

(52) Cooperative Patent Classification (CPC):
**A24F 40/50; A24F 40/51**

(22) Date of filing: **04.03.2022**

(86) International application number:
**PCT/CN2022/079404**

(87) International publication number:
**WO 2023/164945 (07.09.2023 Gazette 2023/36)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Shenzhen Merit Technology Co., Ltd.
Shenzhen, Guangdong 518000 (CN)**

(72) Inventors:
• **WANG, Xin**
  **Shenzhen, Guangdong 518000 (CN)**
• **LIANG, Feng**
  **Shenzhen, Guangdong 518000 (CN)**
• **ZHOU, He**
  **Shenzhen, Guangdong 518000 (CN)**
• **HUANG, Zufu**
  **Shenzhen, Guangdong 518000 (CN)**

(74) Representative: **Manitz Finsterwald
Patent- und Rechtsanwaltspartnerschaft mbB
Martin-Greif-Strasse 1
80336 München (DE)**

(54) **AEROSOL GENERATING DEVICE AND SENSING CONTROL DEVICE THEREFOR**

(57)    An aerosol generating device and a sensing control device thereof. The device includes: a to-be-measured capacitor assembly (100) configured to generate a capacitance change based on whether an aerosol generating substrate is inserted, capacitor plates (A, B, C, D) of the to-be-measured capacitor assembly (100) being distributed along an insertion direction of the aerosol generating substrate (X); and a capacitance processing assembly (200) configured to determine a state of the aerosol generating substrate (X) according to the capacitance of the to-be-measured capacitor assembly (100), and control a heating of the aerosol generating device according to the state of the aerosol generating substrate (X). The capacitance processing assembly (200) is connected to the to-be-measured capacitor assembly (100). The to-be-measured capacitor assembly (100) generates a capacitance change based on whether the aerosol generating substrate (X) is inserted, and the capacitance processing assembly (200) determines the state of the aerosol generating substrate (X) based on the capacitance of the to-be-measured capacitor assembly (100) and control the heating of the aerosol generating device based on the state of the aerosol generating substrate (X), so that the heating control can be automatically performed based on the state of the aerosol generating substrate (X), without requiring a user to use a button to start the heating of the aerosol generating device, thereby improving the convenience of use.

FIG. 1

EP 4 480 333 A1

## Description

### TECHNICAL FIELD

The present disclosure relates to the field of electronic device technologies, and in particular, to an aerosol generating device and a sensing control device thereof.

### BACKGROUND

Aerosol generating devices are electronic devices that atomize an aerosol generating substrate to form aerosols inhalable by users. The aerosol generating devices are pupular among users because they do not contain harmful substances such as tar and will not cause any harm to smokers. For conventional aerosol generating devices, the heating is typically activated by pressing a button and cannot be activated automatically, which is inconvenient to use.

### SUMMARY

According to various embodiments of the present disclosure, an aerosol generating device and a sensing control device thereof are provided.

An induction control device for an aerosol generating device includes:

a to-be-measured capacitor assembly configured to generate a capacitance change based on whether an aerosol generating substrate is inserted, capacitor plates of the to-be-measured capacitor assembly being distributed along an insertion direction of the aerosol generating substrate; and
a capacitance processing assembly configured to determine a state of the aerosol generating substrate based on the capacitance of the to-be-measured capacitor assembly, and control the heating of the aerosol generating device based on the state of the aerosol generating substrate, the capacitance processing assembly being connected to the to-be-measured capacitor assembly.

In an embodiment, the capacitance processing assembly controls the aerosol generating device to start heating when identifying that the aerosol generating substrate is inserted based on the capacitance of the to-be-measured capacitor assembly, and controls the aerosol generating device to stop heating when identifying that the aerosol generating substrate is pulled out based on the capacitance of the to-be-measured capacitor assembly.

In an embodiment, a number of the capacitor plates is three or more, and the capacitance processing assembly controls the aerosol generating device to start preheating when the aerosol generating substrate is in a state of being inserted, and controls the aerosol generating device to start full heating when the aerosol generating substrate is completely inserted. The capacitance processing assembly also controls the aerosol generating device to end heating in advance or reduce the heating temperature when the aerosol generating substrate is in a state of being pulled out.

In an embodiment, the the to-be-measured capacitor assembly includes a to-be-measured capacitor, and the to-be-measured capacitor is connected to the capacitance processing assembly.

In an embodiment, the to-be-measured capacitor comprises the capacitor plates and a base body made of a non-conductive material, and the capacitor plates are disposed on the base body. The number of the capacitor plates is two or more.

In an embodiment, the capacitor plates is are closed annular plates or non-closed annular plates.

In an embodiment, the capacitor plates each include an annular portion and an extension portion disposed on the annular portion, the number of the capacitor plates is two, and the extension portions of the two capacitor plates are disposed opposite to each other.

In an embodiment, the base body is a hollow cylindrical base body, and the capacitor plates are located outside or inside of the base body and distributed along a longitudinal direction of the base body.

In an embodiment, the number of the capacitor plates is two, and the capacitor plates are located on a cylindrical inner wall surface or outer wall surface of the base body.

In an embodiment, the number of the capacitor plates is two, one end of the base body is closed to form a bottom wall, and one of the capacitor plates is disposed on the bottom wall of the base body.

In an embodiment, the to-be-measured capacitor further includes a heating element disposed on the base body.

In an embodiment, the capacitor plates form annular plate groups in a one-to-many or many-to-many manner.

In an embodiment, the to-be-measured capacitor includes a base body made of a conductive material, and the base body is divided into two or more capacitor plates.

In an embodiment, the capacitor plates are closed annular plates or non-closed annular plates.

In an embodiment, the to-be-measured capacitor further includes an insulating member disposed between the capacitor plates.

In an embodiment, the capacitor plates and the insulating member are hollow and are configured to receive the aerosol generating substrate together.

In an embodiment, the capacitor plates form annular plate groups in a one-to-many or many-to-many manner.

In an embodiment, the capacitance processing assembly includes a capacitance acquisition component and a main control unit, and the capacitance acquisition component is connected to the to-be-measured capacitor assembly and the main control unit.

An aerosol generating device includes the above-mentioned sensing control device.

The details of one or more embodiments of the disclosure are set forth in the accompanying drawings and the description below. Other features, objects, and advantages of the disclosure will be apparent from the description, drawings, and claims.

## BRIEF DESCRIPTION OF THE DRAWINGS

In order to illustrate the technical solutions in the embodiments of the present disclosure or prior art more clearly, the accompanying drawings used in the description of the embodiments or prior art will be briefly introduced below. Apparently, the accompanying drawings in the following description are only some embodiments of the present disclosure. For those of ordinary skill in the art, other drawings can also be derived from these drawings without creative effort.

FIG. 1 is a structural block diagram of a sensing control device for an aerosol generating device according to an embodiment.
FIG. 2 is a schematic structural diagram showing various shapes of capacitor plates according to an embodiment.
FIG. 3 is a schematic diagram of a structure of a to-be-measured capacitor assembly according to an embodiment.
FIG. 4 is a schematic diagram of a structure of a to-be-measured capacitor assembly according to another embodiment.
FIG. 5 is a schematic diagram showing capacitor plates forming annular plate groups according to an embodiment.
FIG. 6 is a schematic diagram showing capacitor plates forming annular plate groups according to another embodiment.
FIG. 7 is a schematic diagram showing a bottom plate and a capacitor plate forming an equivalent capacitor according to an embodiment.
FIG. 8 is a schematic diagram showing a bottom plate and a capacitor plate forming an equivalent capacitor according to another embodiment.
FIG. 9 is a schematic diagram of a structure of a capacitor plate according to an embodiment.
FIG. 10 is a schematic diagram of a structure of a to-be-measured capacitor assembly according to yet another embodiment.
FIG. 11 is a schematic diagram of a structure of a to-be-measured capacitor assembly according to yet another embodiment.
FIG. 12 is a schematic diagram showing capacitor plates forming annular plate groups according to yet another embodiment.
FIG. 13 is a schematic diagram showing capacitor plates forming annular plate groups according to yet another embodiment.
FIG. 14 is a schematic diagram showing a bottom plate and a capacitor plate forming an equivalent capacitor according to yet another embodiment.
FIG. 15 is a schematic diagram showing a bottom plate and a capacitor plate forming an equivalent capacitor according to yet another embodiment.
FIG. 16 is a front view of a base body according to an embodiment.
FIG. 17 is a schematic diagram of equivalent capacitances according to an embodiment.
FIG. 18 is a schematic diagram of a principle of detecting position information of an inserted aerosol generating substrate according to an embodiment.
FIG. 19 is a schematic diagram of capacitor plates when a to-be-measured capacitor assembly is an independent measured assembly according to an embodiment.
FIG. 20 is a schematic diagram of capacitor plates when a to-be-measured capacitor component is a series-type composite measured assembly according to an embodiment.
FIG. 21 is a schematic diagram of capacitor plates when a to-be-measured capacitor assembly is a parallel-type composite measured assembly according to an embodiment.
FIG. 22 is a schematic diagram of capacitor plates when a to-be-measured capacitor assembly is a composite-type composite measured assembly according to an embodiment.
FIG. 23 is a schematic diagram of a connection between a touch control chip and a to-be-measured capacitor assembly according to an embodiment.
FIG. 24 is a schematic diagram of a connection between a touch control chip and a to-be-measured capacitor assembly according to another embodiment.

## DETAILED DESCRIPTION OF THE EMBODIMENTS

In order to make the purpose, technical solutions, and advantages of the present disclosure more obvious and understandable, the present disclosure will be described in detailed in conjunction with the accompanying drawings and embodiments. It should be understood that the specific embodiments described herein are merely used to explain the present disclosure and are not intended to limit the present disclosure.

For existing aerosol generating devices, heating action is typically activated by pressing a button, which is inconvenient to use. Based on this, the present disclosure provides an aerosol generating device and a sensing control device thereof. A to-be-measured capacitor assembly generates a capacitance change based on whether an aerosol generating substrate is inserted. A capacitance processing assembly determines a state of the aerosol generating substrate based on the capacitance of the to-be-measured capacitor assembly, and performs heating control on the aerosol generating device based on the state of the aerosol generating substrate, realizing intelligent determination of the insertion of the aerosol generating substrate to realize intelligent starting heating of the aerosol generating substrate, as well as realizing intelligent determination of the pulling out of the aerosol generating substrate to realize intelligent end heating of the aerosol generating substrate, that is, stopping the heating immediately upon the removal of the aerosol generating substrate. In addition, it can avoid unwanted heating when there is no aerosol generating substrate in the aerosol generating device, and prevent dry burning when there is no aerosol generating substrate, thus it has a certain degree of intelligent safety. In an embodiment, the aerosol generating substrate is solid substrate configured to generate aerosol when heated. The aerosol generating substrate preferably includes tobacco-containing material, and the tobacco-containing material contains volatile tobacco flavor compounds released from the substrate when heated. The aerosol generating substrate may include non-tobacco material. The solid substrate may contain materials such as herbaceous plant leaves, and tobacco leaves, etc. In other embodiments, the aerosol generating substrate may also be a liquid substrate, which is atomized to form aerosols when being heated.

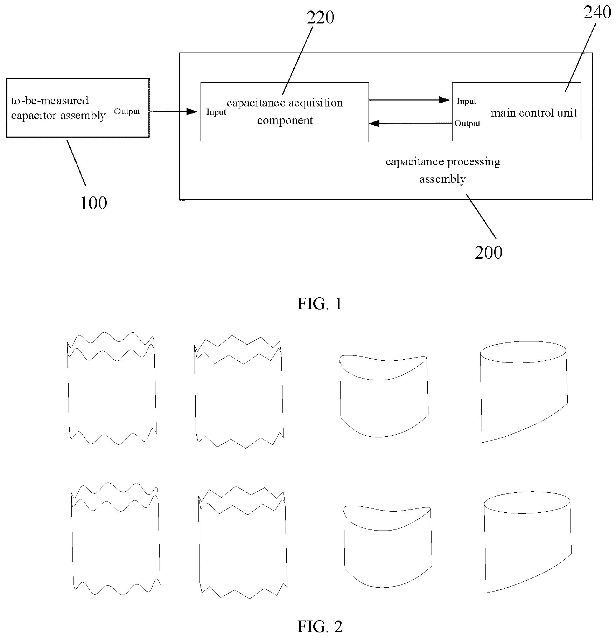

In an embodiment, as shown in FIG. 1, a sensing control device for an aerosol generating device is provided, including a to-be-measured capacitor assembly 100 and a capacitance processing assembly 200. Capacitor plates of the to-be-measured capacitor assembly 100 are distributed along an insertion direction of the aerosol generating substrate. The capacitance processing assembly 200 is connected to the to-be-measured capacitor assembly 100. The to-be-measured capacitor assembly 100 generates a capacitance change based on whether the aerosol generating substrate is inserted. The capacitance processing assembly 200 determines a state of the aerosol generating substrate based on the capacitance of the to-be-measured capacitor assembly 100, and controls the heating of the aerosol generating device based on the state of the aerosol generating substrate.

Specifically, the to-be-measured capacitor assembly 100 can be set in a cavity for inserting the aerosol generating substrate in the aerosol generating device. When the aerosol generating substrate is inserted into or pulled out of the aerosol generating device by a user, the capacitance of the to-be-measured capacitor assembly 100 changes based on an actual insertion position of the aerosol generating substrate. The capacitance processing assembly 200 can pre-save an initial capacitance value of the to-be-measured capacitor assembly 100 as a comparison threshold. After measuring the actual capacitance of the to-be-measured capacitor assembly 100, the capacitance processing assembly 200 can compare the actual capacitance of the to-be-measured capacitor assembly 100 with the comparison threshold to determine whether the aerosol generating substrate is in an inserted state or pulled out state, and then perform heating control on the aerosol generating device based on the state of the aerosol generating substrate. For example, the capacitance processing assembly 200 controls a power supply module to supply power to start the heating when it detects that the aerosol generating substrate is inserted. The capacitance processing assembly 200 also controls the power supply module to turn off the power to end the heating when it detects that the aerosol generating substrate is pulled out.

The number of the capacitor plates of the to-be-measured capacitor assembly 100 is not unique, and may be two, three, or more. For example, when the to-be-measured capacitor assembly 100 includes two capacitor plates, it is possible to identify whether the aerosol generating substrate is in an inserted state or pulled out state based on the capacitance of the to-be-measured capacitor assembly 100. Further, when the to-be-measured capacitor assembly 100 includes three or more capacitor plates, it is possible to identify a present insertion position of the aerosol generating substrate and whether it is in the state of being inserted or being pulled out based on the capacitance of the to-be-measured capacitor assembly 100.

It can be understood that the mode in which the capacitance processing assembly 200 performs heating control on the aerosol generating device based on the state of the aerosol generating substrate is not unique. In an embodiment, the capacitance processing assembly 200 controls the aerosol generating device to start heating when it identifies that the aerosol generating substrate is inserted based on the capacitance of the to-be-measured capacitor assembly 100. The capacitance processing assembly 200 also controls the aerosol generating device to stop heating when it identifies that the aerosol generating substrate is pulled out based on the capacitance of the to-be-measured capacitor assembly 100.

Further, when the number of the capacitor plates is three or more, the capacitance processing assembly 200 controls the aerosol generating device to start preheating when the aerosol generating substrate is in the state of being inserted, and controls the aerosol generating device to start full heating when the aerosol generating substrate is completely inserted. The capacitance processing assembly 200 further controls the aerosol generating device to end the heating in advance or reduce the heating temperature when the aerosol generating substrate is in the state of being pulled out. Specifically, based on the measured capacitance of the to-be-measured capacitor assembly 100, the capacitance processing assembly 200 determines whether the aerosol generating substrate is in the state of being inserted or being pulled out and an actual present position of the aerosol generating substrate. It starts preheating when the aerosol generating substrate is in the state of being inserted, and starts full heating when the aerosol generating substrate is completely inserted. The power of starting the preheating is less than the power of starting the full heating, and specific values of the powers can be set based on an actual situation. When the aerosol generating substrate is in the state of being pulled out, the capacitance processing assembly 200 further controls to end the heating in advance or reduce the heating temperature. Furthermore, if the operation of reducing the heating temperature is performed while the aerosol generating substrate is being pulled out, the capacitance processing assembly 200 completely ends the heating when it identifies that the aerosol generating substrate is completely pulled out.

A specific structure of the capacitance processing assembly 200 is not unique. In an embodiment, the capacitance processing assembly 200 includes a capacitance acquisition component 220 and a main control unit 240. The capacitance acquisition component 220 connects the to-be-measured capacitor assembly 100 and the main control unit 240. An output terminal of the to-be-measured capacitor assembly 100 is connected to an input terminal of the capacitance acquisition component 220. The capacitance acquisition component 220 is connected to an input terminal and output terminal of the main control unit 240. The capacitance acquisition component 220 may be a touch chip, a 555 timer, an RC circuit, or other circuits that can acquire capacitance. The capacitance acquisition component 220 converts the capacitance change into electrical quantities, such as voltage, current, resistance, frequency, phase, etc., and then the main control unit 240 processes the electrical quantity data output by the capacitance acquisition component 220, so as to control the external device. In addition, in an embodiment, the capacitance acquisition component 220 can include a touch chip and a detection circuit. The touch chip is connected to the to-be-measured capacitor assembly 100 through the detection circuit. The detection circuit may specifically include a capacitor configured to be connected in series or parallel with the capacitor plate of the to-be-measured capacitor assembly 100.

In the above-mentioned sensing control device for the aerosol generating device, the to-be-measured capacitor assembly 100 generates a capacitance change based on whether the aerosol generating substrate is inserted, and the capacitance processing assembly 200 determines the state of the aerosol generating substrate based on the capacitance of the to-be-measured capacitor assembly, and controls the heating of the aerosol generating device based on the state of the aerosol generating substrate, realizing automatic heating control based on the state of the aerosol generating substrate without requiring the user to use buttons, thereby improving the convenience of use.

In an embodiment, the to-be-measured capacitor assembly 100 includes a to-be-measured capacitors, and the to-be-measured capacitor is connected to the capacitance processing assembly 200. The to-be-measured capacitor can be designed as an annular capacitor. Specifically, the to-be-measured capacitor can be set in a cavity for inserting the aerosol generating substrate in the aerosol generating device. The capacitance processing assembly 200 measures the actual capacitance value of the to-be-measured capacitor assembly 100 and compares the actual capacitance value with a corresponding preset initial capacitance value to determine whether the capacitance value of the to-be-measured capacitor has changed, so as to obtain the present position of the aerosol generating substrate and whether the aerosol generating substrate is in an inserted state or a pulled out state.

A specific structure of the to-be-measured capacitor is not unique. Material of a base body of the to-be-measured capacitor can include conductive material and non-conductive material. Depending on different materials of the base body, the design of the capacitor plate will also be different accordingly. In an embodiment, the to-be-measured capacitor includes capacitor plates and a base body made of a non-conductive material, and the capacitor plates are arranged on the base body. The number of the capacitor plates is two or more. In the insertion direction of the aerosol generating substrate (for example, when the aerosol generating substrate is inserted vertically), the two or more capacitor plates are located at different horizontal heights. The capacitor plates are closed annular plates or non-closed annular plates. Specifically, the base body can be designed as a hollow cylindrical base body for receiving the aerosol generating substrate. Each of the capacitor plates surrounds the base body, and specifically, the capacitor plates are located outside or inside of the base body and distributed along the longitudinal direction of the base body. In an embodiment, the number of the capacitor plates is two, and the capacitor plates are located on a cylindrical inner wall or outer wall of the base body. Specifically, the cylindrical base body can be designed to be open at both ends, and then the capacitor plates are arranged on the cylindrical inner wall or outer wall of the base body.

The capacitor plate can be a metal plate, which can be a flexible plate or an electroplated plate. The profile of the annular capacitor plate can be circular, rectangular, arched, triangular, spiral, or a composite of these shapes. In addition, as shown in FIG. 2, the edges of the two ends of the capacitor plate can be one or more sections of linear, nonlinear, planar, or non-planar.

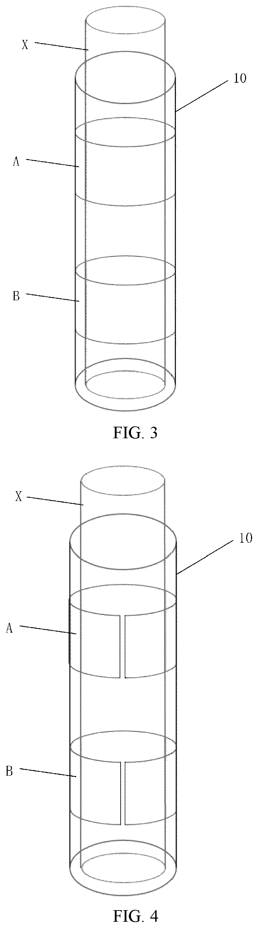

As shown in FIG. 3 and FIG. 4, capacitor plate A and capacitor plate B may be provided on a non-conductive base body 10 by laminating, coating, or electroplating. The capacitor plate A and the capacitor plate B form an equivalent capacitor. Each capacitor plate may have a closed structure or a non-closed structure, or may be any combination of a closed annular plate and a non-closed annular plate.

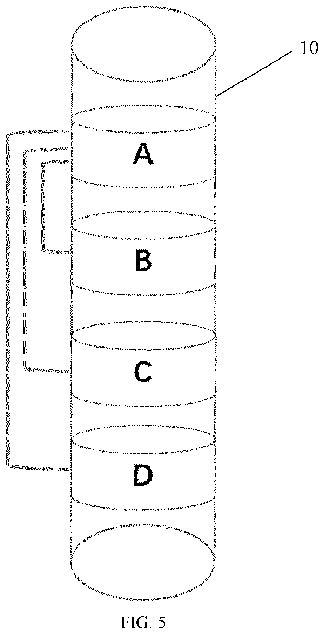

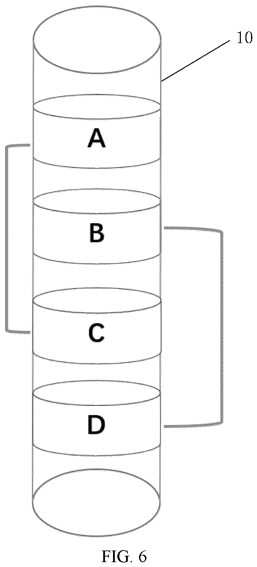

Furthermore, the capacitor plates form annular plate groups in a one-to-many or many-to-many manner. For example, when the number of the capacitor plates is two, the two capacitor plates form an annular plate group. When the number of the capacitor plates is greater than or equal to three, the capacitor plates can form annular plate groups in a one-to-many or many-to-many manner. Specifically, there can be multiple annular plate groups on the base body 10 in one-to-many form. As shown in FIG. 5, the capacitor plate A and the capacitor plate B form a group of electrodes, the capacitor plate A and the capacitor plate C form a group of electrodes, and the capacitor plate A and the capacitor plate D form a group of electrodes. It can also be many-to-many, as shown in FIG. 6, the capacitor plate A and the capacitor plate C form a group of electrodes, and the capacitor plate B and the capacitor plate D form a group of electrodes.

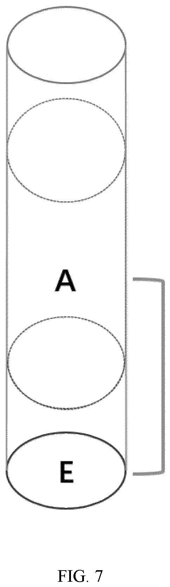

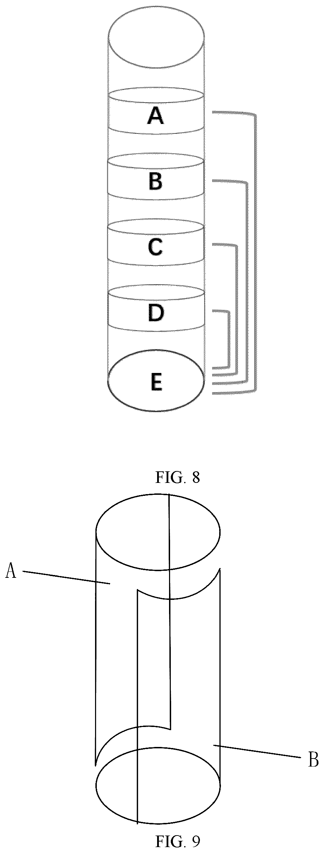

In addition, in an embodiment, a capacitor plate can also be set at the bottom of the base body 10 as a bottom plate, and the bottom plate and other corresponding capacitor plates form equivalent capacitors. The shape of the bottom plate is not unique, and can be rectangular, circular, triangular, arched, spiral, or a composite of these shapes. As shown in FIG. 7, there is a bottom plate E at the bottom of the base body 10, and the bottom plate E and annular capacitor plates form one or more equivalent capacitors. For example, as shown in FIG. 7, the capacitor plate A and the bottom plate E constitute an equivalent capacitor. Alternatively, as shown in FIG. 8, the capacitor plate A and the bottom plate E constitute an equivalent capacitor, the capacitor plate B and the bottom plate E constitute an equivalent capacitor, the capacitor plate C and the bottom plate E constitute an equivalent capacitor, and the capacitor plate D and the bottom plate E constitute an equivalent capacitor.

In an embodiment, the number of the capacitor plates is two, one end of the base body 10 is closed to form a bottom wall, and one of the capacitor plates is disposed on the bottom wall of the base body 10. Specifically, two capacitor plates are disposed longitudinally inside the base body 10, one of which is located on the bottom wall of the base body 10 as a bottom plate, and the other capacitor plate is located on the side wall of the base body 10. By the two capacitor plates, it can be identified whether the aerosol generating substrate is inserted, and the structure is simple.

In addition, the to-be-measured capacitor may also include a heating element disposed on the base body 10. The heating element may specifically be obtained by printing resistive heat generating lines on the base body 10, and is configured to heat the aerosol generating substrate.

In an embodiment, as shown in FIG. 9, the capacitor plate includes an annular portion and an extension portion disposed on the annular portion. The number of the capacitor plates is two, and the extension portions of the two capacitor plates are disposed opposite to each other. Specifically, the capacitor plate A and the capacitor plate B are each designed to be a structure consisting of an annular portion and an extension portion, the extension portion of the capacitor plate is disposed on the annular portion and is perpendicular to the plane where the annular portion is located, and the extension portions of the two capacitor plates are disposed opposite to each other. By measuring the actual capacitance values of the two capacitor plates, the state of the aerosol generating substrate can also be identified.

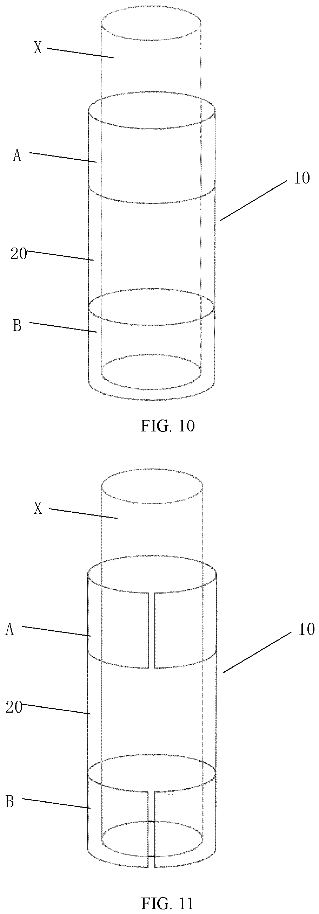

In another embodiment, as shown in FIG. 10, the to-be-measured capacitor includes a base body 10 made of a conductive material. The base body 10 is divided into two or more capacitor plates, and can be specifically divided into three capacitor plates. The capacitor plates form annular plate groups in a one-to-many or many-to-many manner. Specifically, when the base body 10 is made of the conductive material, the base body 10 serves as both a heating element and a capacitor plate. The base body 10 is divided into a plurality of annular capacitor plates, and as shown in FIG. 10 and FIG. 11, the capacitor plate A and the capacitor plate B formed by the division of the base body 10 form an equivalent capacitor. Each capacitor plate is an annular capacitor plate, which can be closed or non-closed, or any combination of the closed annular plate and the non-closed annular plate. The capacitor plate A and the capacitor plate B are made of metal, and can receive the aerosol generating substrate and generate heat through an external alternating magnetic field, thereby heating the aerosol generating substrate. In addition, the to-be-measured capacitor also includes an insulating member arranged between the capacitor plates. For example, an insulating member 20 is arranged between the capacitor plate A and the capacitor plate B. The insulating member 20 may be made of ceramic. In this embodiment, the capacitor plate and the insulating member 20 are hollow and are configured to receive the aerosol generating substrate together.

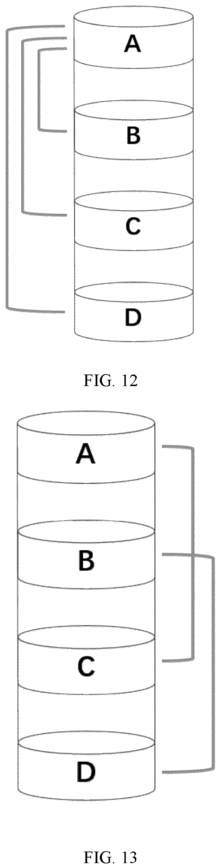

Furthermore, the capacitor plates formed by the division of the base body 10 form a plurality of groups of annular plates, in the form of one-to-many. As shown in FIG. 12, the capacitor plate A and the capacitor plate B form a group of electrodes, the capacitor plate A and the capacitor plate C form a group, and the capacitor plate A and the capacitor plate D form a group of electrodes. It can also be many-to-many, as shown in FIG. 13, the capacitor plate A and the capacitor plate C form a group of electrodes, and the capacitor plate B and the capacitor plate D form a group of electrodes.

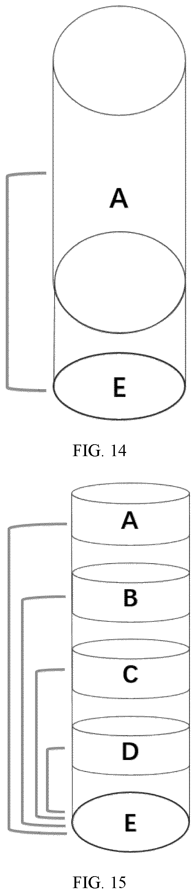

Correspondingly, in an embodiment, a capacitor plate divided from the base body 10 can also be used as the bottom plate of the base body 10, and the bottom plate and other corresponding capacitor plates form equivalent capacitors. The shape of the bottom plate can also be rectangular, circular, triangular, arched, spiral, or a composite of these shapes. As shown in FIG. 14, there is a bottom plate E at the bottom of the base body 10, and the bottom plate E and the annular capacitor plate form one or more equivalent capacitors. For example, as shown in FIG. 14, the capacitor plate A and the bottom plate E constitute an equivalent capacitor. Alternatively, as shown in FIG. 15, the capacitor plate A and the bottom plate E constitute an equivalent capacitor, the capacitor plate B and the bottom plate E constitute an equivalent capacitor, the capacitor plate C and the bottom plate E constitute an equivalent capacitor, and the capacitor plate D and the bottom plate E constitute an equivalent capacitor.

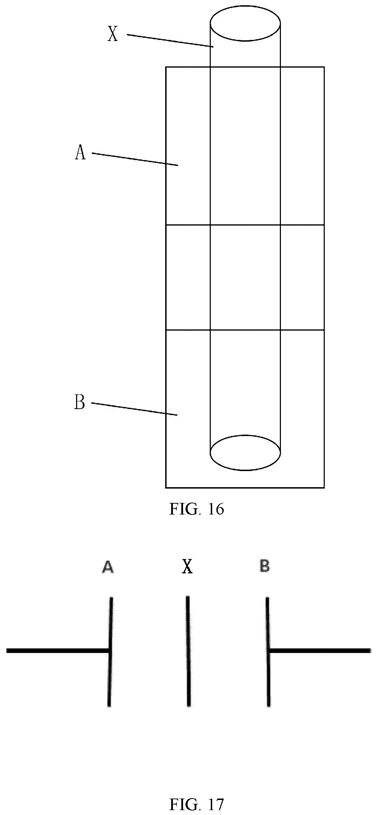

FIG. 16 is a simplified schematic diagram in which the aerosol generating substrate X is inserted into the base body. The aerosol generating substrate X is equivalent to a plate of a capacitor. The capacitor plate A and the aerosol generating substrate X form a capacitor ①, and the capacitor plate B and the aerosol generating substrate X form a capacitor ②. The schematic diagram of the formed equivalent capacitors is shown in FIG. 17. A theoretical formula of capacitance is as follows:

$$C = \varepsilon \frac{S}{d}$$

where C refers to a capacitance value, $\varepsilon$ refers to a dielectric constant between the capacitor plates, S refers to a plate area, and d refers to a distance between the plates. Because the conductivity of the aerosol generating substrate X is much smaller than that of the capacitor plate A and the capacitor plate B, when the aerosol generating substrate X is inserted between the capacitor plate A and the capacitor plate B, the dielectric constant $\varepsilon$ of the material between the capacitor plate A and the capacitor plate B is changed, causing the capacitance between the capacitor plate A and the capacitor plate B to change. Depending on whether the capacitance between the capacitor plate A and the capacitor plate B changes, it can be identified whether the aerosol generating substrate X is inserted between the capacitor plate A and the capacitor plate B. The aerosol generating substrate X can be a cigarette, a solid medicine or other solid substances. In addition, the aerosol generating substrate X can also be a liquid substance contained in a solid container.

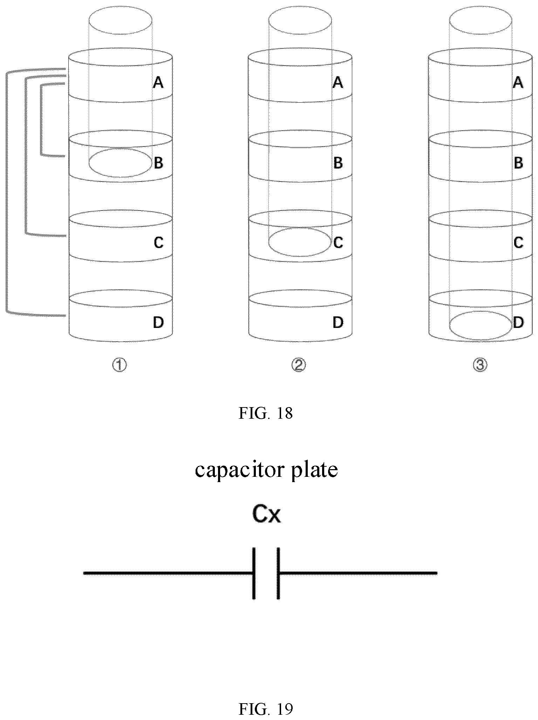

By setting a plurality of annular capacitor plates, for example, setting three or four annular capacitor plates, when the aerosol generating substrate reaches the position of a certain annular capacitor plate, the change of the capacitance corresponding to the annular capacitor plate at the corresponding position can be measured, thereby determining the position of the aerosol generating substrate. According to this characteristic, the insertion action and the position of the aerosol generating substrate can be obtained, and then heating can be started, as well as the pulled out action and the position of the aerosol generating substrate can be obtained, and then the heating can be stopped. For example, as shown in FIG .18, the capacitor plate A and the capacitor plate B form a capacitor, the capacitor plate A and the capacitor plate C form a capacitor, and the capacitor plate A and the capacitor plate D form a capacitor. When the aerosol generating substrate is inserted into the position of the capacitor plate B as shown in FIG. 18-①, the capacitance of the capacitor plate A and the capacitor plate B changes. When the aerosol generating substrate is inserted into the position of the capacitor plate C as shown in FIG. 18-②, the capacitance of the capacitor plate A and the capacitor plate C changes. When the aerosol generating substrate is inserted into the position of the capacitor plate D as shown in FIG. 18-③, the capacitance of the capacitor plate A and the capacitor plate D changes. Based on this characteristic, position information of the inserted aerosol generating substrate can be obtained.

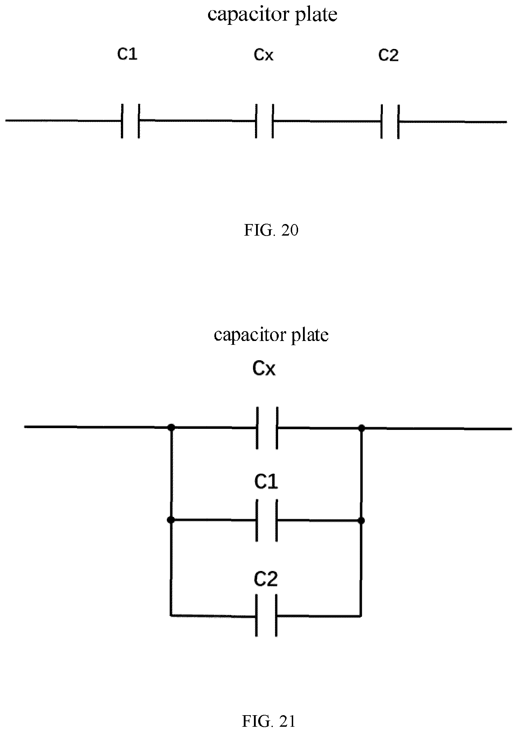

Based on different connection manners of the to-be-measured capacitor assembly 100, the to-be-measured capacitor assembly 100 can be categorized into two types: independent measured assembly and composite measured assembly. The composite measured assembly can further include a series-type and a parallel-type. As shown in FIG. 19, for the independent measured assembly, only the to-be measured capacitor needs to be measured, and Cx refers to a capacitor plate. For the series-type composite measured assembly, as shown in FIG. 20, capacitor C1 and capacitor C2 are external measured capacitors connected in series with the capacitor plate Cx, and the capacitor C1 and the capacitor C2 are specifically capacitors in the capacitance acquisition component 220. The number of the capacitors connected in series with the capacitor plate Cx is not limited, it can be one, two, or more and can be adjusted according to actual needs. In addition, the capacitors connected in series with the capacitor plate Cx can be finished capacitors produced by a capacitor manufacturer or capacitors composed of structural parts.

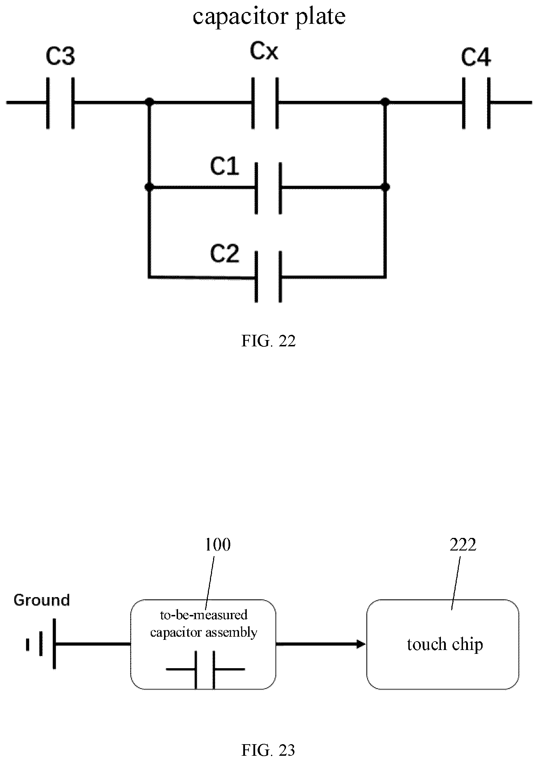

Further, for the parallel-type composite measured assembly, as shown in FIG. 21, capacitor C1 and capacitor C2 are external measured capacitors connected in parallel with the capacitor plate Cx. The capacitor C1 and the capacitor C2 are specifically capacitors in the capacitance acquisition component 220. The number of capacitors in parallel with the capacitor plate Cx is not limited, it can also be one, two or more, and can be adjusted according to actual needs. The capacitors in parallel with the capacitor plate Cx can be finished capacitors produced by a capacitor manufacturer or capacitors composed of structural parts. For the composite measured assembly of a parallel and series composite type, as shown in FIG. 22, capacitor C1 and capacitor C2 are external measured capacitors connected in parallel with the capacitor plate Cx, and capacitor C3 and capacitor C4 are external measured capacitors connected in series with the capacitor plate Cx. The capacitor C 1, the capacitor C2, the capacitor C3 and the capacitor C4 are specifically capacitors in the capacitance acquisition component 220. The number of capacitors connected in parallel with the capacitor plate Cx is not limited, it can be one, two, or more, and can be adjusted according to actual needs. The capacitors connected in parallel with the capacitor plate Cx can be finished capacitors produced by a capacitor manufacturer or capacitors composed of structural parts. The number of capacitors connected in series with the capacitor plate Cx is not limited, it can be one, two, or more, and can be adjusted according to actual needs. The capacitors connected in series with the capacitor plate Cx can be finished capacitors produced by a capacitor manufacturer or capacitors composed of structural parts.

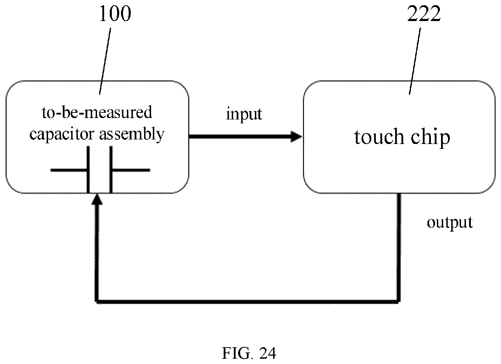

Taking a touch chip 222 being used as the capacitance acquisition component 220 as an example, a capacitance scanning principle of the touch chip 222 includes mutual capacitance scanning and self-capacitance scanning. Self-capacitance scanning is a scanning method of self-transmission and self-reception, and the capacitance measured by the touch chip 222 is the capacitance between an electrode and the ground. For mutual capacitance scanning, the touch chip 222 measures the capacitance between two electrodes. Based on different capacitance scanning methods of the touch chip, the connection between the touch chip 222 and the to-be-measured capacitor assembly 100 includes the following two manners. As shown in FIG. 23, for the self-capacitance scanning, one of the plates of the to-be-measured capacitor in the to-be-measured capacitor assembly 100 is connected to the ground, and the other plate is connected to a signal acquisition input terminal of the touch chip 222. As shown in FIG. 24, for the mutual capacitance scanning, one of the plates of the to-be-measured capacitor in the to-be-measured capacitor assembly 100 is connected to a signal output terminal of the touch chip 222, and the other plate is connected to the signal acquisition input terminal of the touch chip 222.

An initial capacitance value of the to-be-measured capacitor assembly 100 is periodically acquired and updated by the touch chip 222, and the initial capacitance value is used as the threshold value for determining the capacitance change. During insertion and pulling out of the aerosol generating substrate, the touch chip acquires a change of the capacitance value of each group of annular plates. The main control unit 240 can determine the position of the aerosol generating substrate and whether it is in the state of being inserted or being pulled out based on the capacitance value measured by the touch chip 222.

Further, the main control unit 240 may include a control chip and a discrete device. The control chip is configured for collecting data information from the touch chip 222 and making control actions based on the data information from the touch chip 222. The discrete device includes a power supply chip, a resistor, a capacitor, an inductor, a crystal oscillator, a memory, a logic gate circuit, etc. that support an operation of the control chip. During the insertion of the aerosol generating substrate, the touch chip 222 identifies the state of being inserted gradually based on the capacitance change of the annular capacitor plates at specific positions, and the main control unit 240 can start preheating in advance. When the aerosol generating substrate is inserted, the touch chip 222 identifies the completely inserted state based on the capacitance change of the annular capacitor plates at specific positions, and the main control unit 240 starts full heating. During the pulling out of the aerosol generating substrate, the touch chip 222 identifies the state of being pulled out gradually based on the capacitance change of the annular capacitor plates at specific positions, and the main control unit 240 can end the heating in advance or reduce the heating temperature. When the aerosol generating substrate is pulled out, the touch chip 222 identifies the completely pulled out state based on the capacitance change of the annular capacitor plates at specific positions, and the main control unit 240 completely ends the heating.

In an embodiment, an aerosol generating device is also provided, including the above-mentioned sensing control device.

In the above-mentioned aerosol generating device, the capacitance of the to-be-measured capacitor assembly changes based on whether an aerosol generating substrate is inserted. The capacitance processing assembly determines a state of the aerosol generating substrate based on the capacitance of the to-be-measured capacitor assembly, and controls the heating of the aerosol generating device based on the state of the aerosol generating substrate, realizing automatic heating control based on the state of the aerosol generating substrate without requiring a user to start heating the aerosol generating substrate using buttons, thereby improving the convenience of use.

The technical features in the above embodiments may be randomly combined. For concise description, not all possible combinations of the technical features in the above embodiments are described. However, provided that the combinations of the technical features do not conflict with each other, all combinations of the technical features are considered as falling within the scope recorded in this specification.

The above-mentioned embodiments only illustrate several embodiments of the present disclosure, and the descriptions of which are relatively specific and detailed, but should not be construed as limitations to the scope of the present disclosure. It should be noted that, for those skilled in the art, variations and improvements can be made without departing from the concept of the present disclosure, which all belong to the protection scope of the present disclosure. Therefore, the protection scope of the present disclosure shall be subject to the appended claims.

**Claims**

1. A sensing control device for an aerosol generating device, **characterized in that** the sensing control device comprises:

a to-be-measured capacitor assembly configured to generate a capacitance change based on whether an aerosol generating substrate is inserted, capacitor plates of the to-be-measured capacitor assembly being distributed along an insertion direction of the aerosol generating substrate; and
a capacitance processing assembly configured to determine a state of the aerosol generating substrate based on a capacitance of the to-be-measured capacitor assembly, and control a heating of the aerosol generating device based on the state of the aerosol generating substrate, the capacitance processing assembly being connected to the to-be-measured capacitor assembly.

2. The sensing control device according to claim 1, **characterized in that** the capacitance processing assembly controls the aerosol generating device to start heating when identifying that the aerosol generating substrate is inserted based on the capacitance of the to-be-measured capacitor assembly, and controls the aerosol generating device to stop heating when identifying that the aerosol generating substrate is pulled out based on the capacitance of the to-be-measured capacitor assembly.

3. The sensing control device according to claim 2, **characterized in that** a number of the capacitor plates is three or more, and the capacitance processing assembly controls the aerosol generating device to start preheating when the aerosol generating substrate is in a state of being inserted, and controls the aerosol generating device to start full heating when the aerosol generating substrate is completely inserted; and
the capacitance processing assembly also controls the aerosol generating device to end the heating in advance or reduce a heating temperature when the aerosol generating substrate is in a state of being pulled out.

4. The sensing control device according to claim 1, **characterized in that** the to-be-measured capacitor assembly comprises a to-be-measured capacitor, and the to-be-measured capacitor is connected to the capacitance processing assembly.

5. The sensing control device according to claim 4, **characterized in that** the to-be-measured capacitor comprises the capacitor plates and a base body made of a non-conductive material, and the capacitor plates are disposed on the base body; and
wherein a number of the capacitor plates is two or more.

6. The sensing control device according to claim 5, **characterized in that** the capacitor plates are closed annular plates or non-closed annular plates.

7. The sensing control device according to claim 5, **characterized in that** the capacitor plates each comprise an annular portion and an extension portion disposed on the annular portion , the number of the capacitor plates is two, and the extension portions of the two capacitor plates are disposed opposite to each other.

8. The sensing control device according to claim 5, **characterized in that** the base body is a hollow cylindrical base body, and the capacitor plates are located outside or inside of the base body and distributed along a longitudinal direction of the base body.

9. The sensing control device according to claim 8, **characterized in that** a number of the capacitor plates is two, and the capacitor plates are located on a cylindrical inner wall or outer wall of the base body .

10. The sensing control device according to claim 8, **characterized in that** a number of the capacitor plates is two, one end of the base body is closed to form a bottom wall, and one of the capacitor plates is disposed on the bottom wall of the base body .

11. The sensing control device according to claim 5, **characterized in that** the to-be-measured capacitor further comprises a heating element disposed on the base body.

12. The sensing control device according to claim 5, **characterized in that** the capacitor plates form annular plate groups in a one-to-many or many-to-many manner.

13. The sensing control device according to claim 4, **characterized in that** the to-be-measured capacitor comprises a base body made of a conductive material, and the base body is divided into two or more of the capacitor plates.

14. The sensing control device according to claim 13, **characterized in that** the capacitor plates are are closed annular plates or non-closed annular plates.

15. The sensing control device according to claim 13, **characterized in that** the to-be-measured capacitor further comprises an insulating member arranged between the capacitor plates.

16. The sensing control device according to claim 15, **characterized in that** the capacitor plates and the insulating member are hollow and are configured to receive the aerosol generating substrate together.

17. The sensing control device according to claim 13, **characterized in that** the capacitor plates form annular plate groups in a one-to-many or many-to-many manner.

18. The sensing control device according to claim 1, **characterized in that** the capacitance processing assembly comprises a capacitance acquisition component and a main control unit, and the capacitance acquisition component is connected to the to-be-measured capacitor assembly and the main control unit.

19. An aerosol generating device, **characterized in that** the aerosol generating device comprises the sensing control device according to any one of claims 1 to 18.

FIG. 1

FIG. 2

FIG. 3

FIG. 4

FIG. 5

FIG. 6

FIG. 7

FIG. 8

FIG. 9

X

A

20

B

10

FIG. 10

X

A

20

B

10

FIG. 11

FIG. 12

FIG. 13

FIG. 14

FIG. 15

X

A

B

FIG. 16

A     X     B

FIG. 17

FIG. 18

capacitor plate

Cx

FIG. 19

capacitor plate

C1          Cx          C2

FIG. 20

capacitor plate

Cx

C1

C2

FIG. 21

capacitor plate

C3    Cx    C4

C1

C2

FIG. 22

100    222

Ground

to-be-measured
capacitor assembly

touch chip

FIG. 23

FIG. 24

<div align="center">

**INTERNATIONAL SEARCH REPORT**

</div>

| | International application No. |
|---|---|
| | **PCT/CN2022/079404** |

| | |
|---|---|
| **A.** | **CLASSIFICATION OF SUBJECT MATTER** |
| | A24F 40/51(2020.01)i; A24F 40/50(2020.01)i |
| | According to International Patent Classification (IPC) or to both national classification and IPC |

| | |
|---|---|
| **B.** | **FIELDS SEARCHED** |
| Minimum documentation searched (classification system followed by classification symbols) |
| A24F |
| Documentation searched other than minimum documentation to the extent that such documents are included in the fields searched |
| Electronic data base consulted during the international search (name of data base and, where practicable, search terms used) |
| CNTXT, VEN: 电子烟, 电容, 加热, 控制, electronic cigarette, capacitance, heat, control |

| | |
|---|---|
| **C.** | **DOCUMENTS CONSIDERED TO BE RELEVANT** |

| Category* | Citation of document, with indication, where appropriate, of the relevant passages | Relevant to claim No. |
|---|---|---|
| X | WO 2021157841 A1 (KT & G CORP.) 12 August 2021 (2021-08-12) description, paragraphs 39-64, and figures 1-6 | 1-19 |
| X | CN 112315031 A (CHINA TOBACCO HENAN INDUSTRIAL CO., LTD.) 05 February 2021 (2021-02-05) description, pages 3-5, and figure 1 | 1-19 |
| X | WO 2021246644 A1 (KT & G CORP.) 09 December 2021 (2021-12-09) description, paragraphs 25-66, and figures 1-12 | 1-19 |
| A | CN 113197361 A (SHENZHEN CHENYU TECHNOLOGY CO., LTD.) 03 August 2021 (2021-08-03) entire document | 1-19 |
| A | WO 2021152319 A1 (NICOVENTURES TRADING LTD.) 05 August 2021 (2021-08-05) entire document | 1-19 |

☐ Further documents are listed in the continuation of Box C.    ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **16 July 2022** | **28 July 2022** |

| Name and mailing address of the ISA/CN | Authorized officer |
|---|---|
| **China National Intellectual Property Administration (ISA/ CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2022/079404**

| Patent document cited in search report | | | Publication date (day/month/year) | Patent family member(s) | | | Publication date (day/month/year) |
|---|---|---|---|---|---|---|---|
| WO | 2021157841 | A1 | 12 August 2021 | CN | 113507849 | A | 15 October 2021 |
| | | | | JP | 2022522578 | A | 20 April 2022 |
| | | | | KR | 20210138547 | A | 19 November 2021 |
| | | | | EP | 3886618 | A1 | 06 October 2021 |
| | | | | KR | 20210101042 | A | 18 August 2021 |
| CN | 112315031 | A | 05 February 2021 | | None | | |
| WO | 2021246644 | A1 | 09 December 2021 | KR | 20210150155 | A | 10 December 2021 |
| CN | 113197361 | A | 03 August 2021 | | None | | |
| WO | 2021152319 | A1 | 05 August 2021 | GB | 202001342 | D0 | 18 March 2020 |
| | | | | TW | 202137897 | A | 16 October 2021 |
| | | | | AR | 121218 | A1 | 27 April 2022 |

Form PCT/ISA/210 (patent family annex) (January 2015)